# EUROPEAN PATENT APPLICATION

(11) **EP 2 993 773 A1**
(43) Date of publication of application: **09.03.2016**
(21) Application number: 15183109.6
(22) Date of filing: 31.08.2015
(51) Int. Cl.: H02M 3/158, G01R 19/00, H02M 1/00

(54) **BIDIRECTIONAL CURRENT-SENSE CIRCUIT**

(30) Priority: 05.09.2014 US 201414478029
(71) Applicant: Murata Manufacturing Co., Ltd., Nagaokakyo-shi, Kyoto 617-8555 (JP)
(72) Inventor: McIntyre, Bradley, Mansfield, MA 02048-1151 (US)
(74) Representative: Laufhütte, Dieter

(57) **Abstract**

A bi-directional voltage converter with a current-sensing circuit includes a first sub-circuit including a high-voltage terminal, a first switching device, and a first primary winding of a first transformer; a second sub-circuit including a second switching device, a second primary winding of a second transformer, and ground; a low-voltage terminal connected, via an inductor, to a point between the first the second sub-circuits; a third switching device connected to a first secondary winding of the first transformer; a fourth switching device connected to a second secondary winding of the second transformer; and a control circuit configured to control the switching devices. The third and fourth switching devices are included in the current-sensing circuit and are connected to a current-sense terminal, and the current-sensing circuit generates a voltage waveform at the current-sense terminal representing a current flowing through at least one of the first and the second switching devices.

## Description

### BACKGROUND OF THE INVENTION

### 1. Field of the Invention

The present invention relates to power electronics. More specifically, the present invention relates to current sensing in bidirectional voltage converters.

### 2. Description of the Related Art

A current-sensing circuit is typically included in a voltage converter to provide a measurement of current through the switching elements of the voltage converter. This measurement can be used, for example, to control operation of the voltage converter or to detect faults such as overcurrent.

Bidirectional voltage converters have been used to link two or more different DC buses together. For example, a bidirectional voltage converter is typically included in a hybrid vehicle to transfer energy between a high-voltage battery used to power an electric motor of the hybrid vehicle and a conventional 12-volt battery used to power conventional electrical systems of the hybrid vehicle (e.g., radio, lights, dashboard interface, etc.). Bidirectional voltage converters have also been used in aerospace applications to couple batteries to a high-voltage bus used for various flight control systems. In bidirectional voltage converters, both positive and negative currents are output, such that a current-sensing circuit is required to sense current flowing in either direction. Current sensing is necessary in bidirectional voltage converters to control the transfer of energy (e.g., between high- and low-voltage batteries) and to provide detection of over-current conditions. Current-sense amplifiers have typically been included in bidirectional current-sensing circuits so that current flowing in either direction can be detected and measured. The current-sense amplifiers need to have a high small-signal bandwidth to monitor instantaneous currents in bidirectional voltage converters that operate at relatively high frequencies. More specifically, unless a current-sense amplifier has a bandwidth that is higher than the bandwidth of a current loop of a bidirectional voltage converter, the current-sense amplifier will be too slow to control the current loop. For example, the current-sense amplifier could have a switching frequency that is 5 to 10 times higher than that of the current loop to ensure that current feedback information is transmitted fast enough to control the current loop. The current-sense amplifiers also need to have a wide common mode input voltage range to sense current on the high-side of bidirectional voltage converters.

The current-sense amplifiers typically sense current based on a voltage drop across sense resistors. However, due to the power losses caused by sense resistors, current-sense amplifiers reduce the efficiency of the bidirectional voltage converters.

Bidirectional current-sense amplifier circuits have been manufactured as integrated circuits to attempt to increase the efficiency of these circuits. However, these integrated current-sense amplifiers typically set an output current-sense signal representing zero current to an intermediate reference voltage, for example, 2.5 V. Current in one direction is represented as a voltage from the reference voltage to an upper limit or a full scale, for example, from 2.5 V to 5.0 V. Current in the opposite direction is represented as a voltage from the reference voltage to a lower limit or zero, for example, from 2.5 V to 0.0 V. Thus, only half of the full-scale voltage is used to represent current in each direction. Additional circuitry is required, such as amplifiers, bidirectional switches, and the like, to allow for a full-scale voltage represented in both current directions (e.g., from 0.0 V to 5.0 V in one direction and from 0.0 V to 5.0 V in the other direction), with zero amps represented as zero volts in both current directions.

### SUMMARY OF THE INVENTION

To overcome the problems described above, preferred embodiments of the present invention provide a bidirectional non-isolated DC-DC converter including a bidirectional current-sensing circuit with simple and efficient current sensing using a full-scale current-sense signal representing current flowing in either direction, even at high frequencies.

According to a preferred embodiment of the present invention, a bi-directional voltage converter with a current-sensing circuit includes a first sub-circuit including a high-voltage terminal, a first switching device, and a first primary winding of a first transformer connected in series with each other; a second sub-circuit including a second switching device, a second primary winding of a second transformer, and a ground terminal connected in series with each other; a low-voltage terminal connected, via an inductor, to a point between the first sub-circuit and the second sub-circuit; a third switching device and a first secondary winding of the first transformer connected in series with each other; a fourth switching device and a second secondary winding of the second transformer connected in series with each other; and a control circuit configured to control on and off switching of the first, second, third, and fourth switching devices. The third and fourth switching devices are included in the current-sensing circuit and are connected to a current-sense terminal, and the current-sensing circuit generates a voltage waveform at the current-sense terminal representing a current flowing through at least one of the first switching device and the second switching device.

Preferably, the control circuit is configured to control the first and third switching devices to turn on and off at the same time or substantially at the same time and the second and fourth switching devices to turn on and off at the same time or substantially at the same time, or the control circuit is configured to control the third switching device to turn on or off at an end of a delay period after the first switching device turns on or off and the fourth switching device to turn on or off at an end of a delay period after the second switching device turns on or off.

The bi-directional voltage converter further preferably includes a first RC circuit connected between the control circuit and the third switching device and configured to delay the third switching device from turning on or off and a second RC circuit connected between the control circuit and the fourth switching device and configured to delay the fourth switching device from turning on or off. Preferably, the first and third switching devices are on and the second and fourth switching devices are off during an ON time of a buck-mode operation of the voltage converter, and the first and third switching devices are off and the second and fourth switching devices are on during an OFF time of the buck-mode operation of the voltage converter.

Preferably, the first and third switching devices are off and the second and fourth switching devices are on during an ON time of a boost-mode operation of the voltage converter, and the first and third switching devices are on and the second and fourth switching devices are off during an OFF time of the boost-mode operation of the voltage converter. Preferably, the current-sense terminal includes a diode and an output resistor connected in parallel to ground, and the diode is arranged to clamp a voltage across the output resistor to a voltage drop of the diode.

The current-sense terminal preferably includes a reference voltage and a voltage divider arranged to bias the current-sense terminal.

The bi-directional voltage converter further preferably includes a fifth switching device connected in series with the third switching device and the first secondary winding and a sixth switching device connected in series with the fourth switching device and the second secondary winding. Preferably, the control circuit is configured to turn the fifth switching device on or off at the same time or substantially at the same time as the third switching device and to turn the sixth switching device on or off at the same time or substantially at the same time as the fourth switching device. Preferably, the fifth switching device is arranged to prevent current from conducting through a body diode of the third switching device when the third switching device is off, and the sixth switching device is arranged to prevent current from conducting through a body diode of the fourth switching device when the fourth switching device is off.

At least one of the first through sixth switching devices is preferably a metal-oxide-semiconductor field-effect transistor.

Preferably, the control circuit includes an analog-to-digital converter or an analog comparator, and the current-sense terminal is connected the analog-to-digital converter or the analog comparator of control device. The bi-directional voltage converter further preferably includes snubber circuits connected across each of the primary and secondary windings of each of the first and second transformers, where the snubber circuits each include a resistor. At least one of the snubber circuits further preferably includes a capacitor.

The bi-directional voltage converter further preferably includes a first AND gate including an output connected to a control terminal of the first switching device and inputs connected to a bias voltage and a control signal for the first switching device and a second AND gate including an output connected to a control terminal of the second switching device and inputs connected to the bias voltage and a control signal for the second switching device.

The bi-directional voltage converter further preferably includes a voltage divider connected to the low-voltage terminal and an average current-mode control circuit including a first input connected to the voltage divider and a second input connected to the current-sense terminal. Preferably, the average-mode current control circuit includes the control circuit and a pulse-width-modulation controller, and the pulse-width-modulation controller of the average current-mode control circuit outputs a pulse-width-modulation signal to control the first and second switching devices. Preferably, the average-mode current control circuit includes a first analog-to-digital converter having inputs connected to the first input and a digital reference voltage, and an output connected to a voltage-mode controller; a second analog-to-digital converter having inputs connected to the second input and an output of the voltage-mode controller, and an output connected to a current-mode controller; and an analog comparator having inputs connected to the second input and a current-limit reference signal, and an output connected to the pulse-width-modulation controller.

According to a preferred embodiment of the present invention, a multi-phase voltage converter includes a bi-directional voltage converter with a current-sensing circuit as set forth herein and at least one secondary voltage converter connected in parallel with the bi-directional voltage converter. The at least one secondary voltage converter includes a secondary driver, a first secondary switching device connected to the high-voltage terminal, and a second secondary switching device connected to the low-voltage terminal via a secondary inductor, and the control circuit is further configured to control on and off switching of the first secondary switching device and the second secondary switching device.

The above and other features, elements, steps, configurations, characteristics and advantages of the present invention will become more apparent from the following detailed description of preferred embodiments of the present invention with reference to the attached drawings.

### BRIEF DESCRIPTION OF THE DRAWINGS

Fig. 1 is a circuit diagram of a bidirectional non-isolated DC-DC converter including a bi-directional current-sensing circuit according to a first preferred embodiment of the present invention.
Figs. 2-4 show waveforms associated with the bidirectional non-isolated DC-DC converter shown in Fig. 1 operating in a buck mode.
Figs. 5-7 show waveforms associated with the bidirectional non-isolated DC-DC converter shown in Fig. 1 operating in a boost mode.
Fig. 8 is a circuit diagram of a bidirectional non-isolated DC-DC converter including a bi-directional current-sensing circuit according to a second preferred embodiment of the present invention.
Fig. 9 is a circuit diagram of an average current-mode control circuit according to a preferred embodiment of the present invention.
Fig. 10 is a circuit diagram of a multi-phase converter according to a preferred embodiment of the present invention.

### DETAILED DESCRIPTION OF PREFERRED EMBODIMENTS

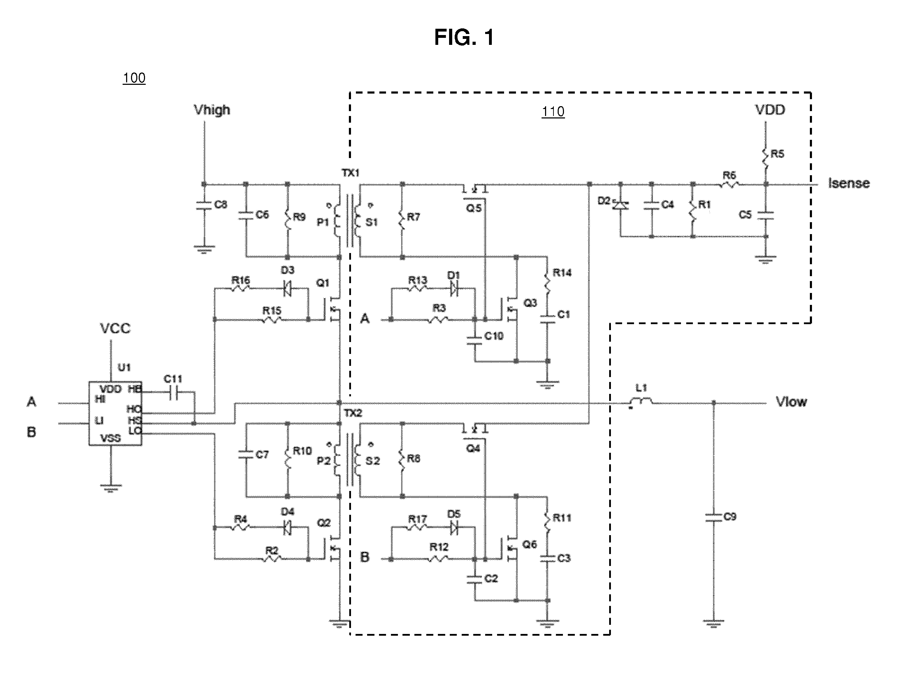

Preferred embodiments of the present invention will now be described in detail with reference to Figs. 1 to 10. Note that the following description is in all aspects illustrative and not restrictive and should not be construed to restrict the applications or uses of the present invention in any manner.

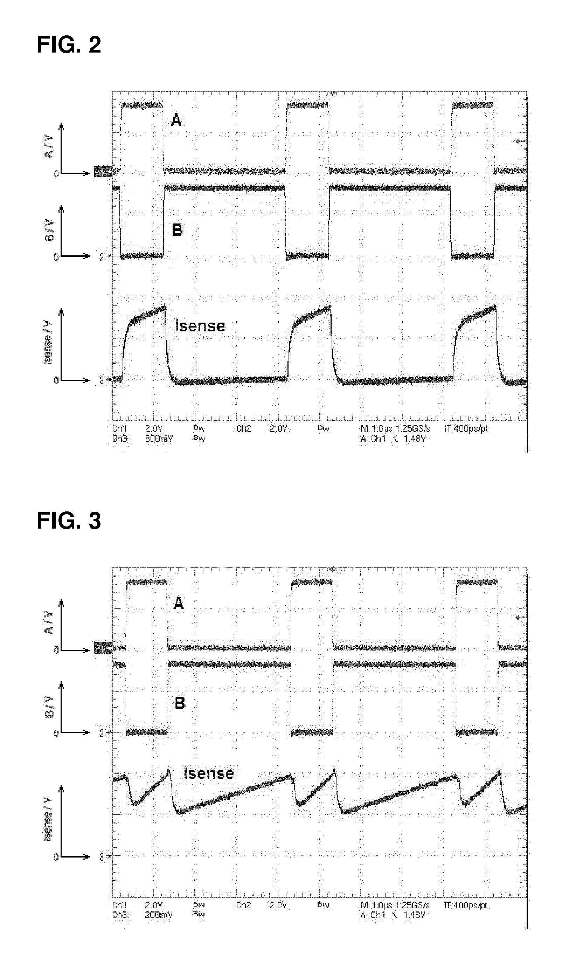

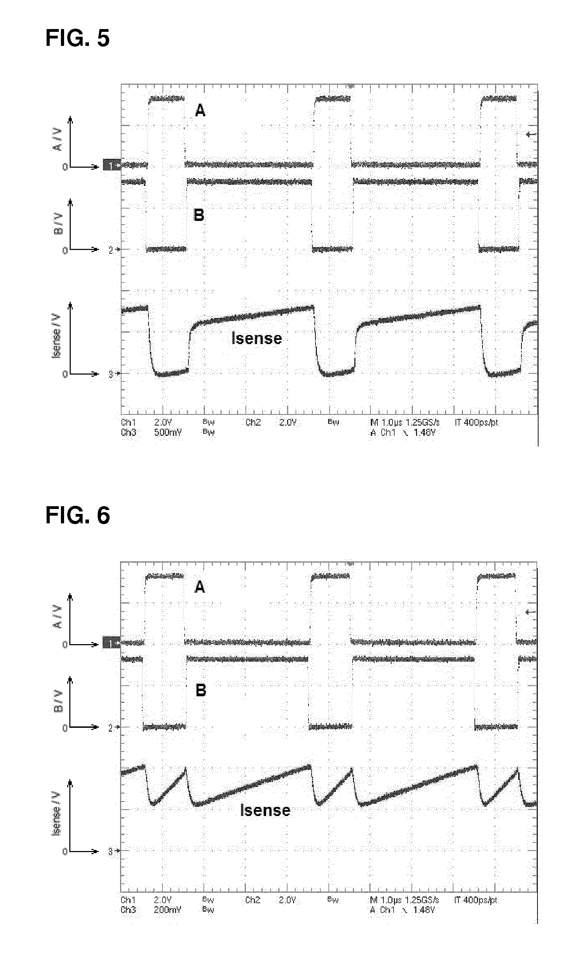

Fig. 1 is a circuit diagram of a bidirectional non-isolated DC-DC converter 100 including a bi-directional current-sensing circuit 110 according to a first preferred embodiment of the present invention. Figs. 2-4 show waveforms associated with the bidirectional non-isolated DC-DC converter 100 shown in Fig. 1 operating in a buck mode. Figs. 5-7 show waveforms associated with the bidirectional non-isolated DC-DC converter 100 shown in Fig. 1 operating in a boost mode.

Fig. 1 shows the bidirectional non-isolated DC-DC converter 100 including the bidirectional current-sensing circuit 110. Preferably, the bidirectional non-isolated DC-DC converter 100 has two modes of operation - buck mode and boost mode. In buck mode, power is transferred from a high-voltage terminal Vhigh to a low-voltage terminal Vlow. In boost mode, power is transferred from the low-voltage terminal Vlow to the high-voltage terminal Vhigh. In both buck and boost modes, the high-voltage terminal Vhigh has a higher voltage potential than the low-voltage terminal Vlow.

The bidirectional non-isolated DC-DC converter 100 preferably includes the primary windings (P1 and P2) of two current-sense transformers (TX1 and TX2), six resistors (R2, R4, R9, R10, R15, and R16), two transistors (Q1 and Q2), five capacitors (C6, C7, C8, C9, and C11), one inductor (L1), two diodes (D3 and D4), and one driver (U1), for example. Transistors Q1 and Q2 are preferably metal-oxide-semiconductor field-effect transistors (MOSFETs), and more preferably power MOSFETs, for example. Specific examples of transistors Q1 and Q2 include silicon power MOSFETs, insulated gate bipolar transistors (IGBTs), and gallium nitride (GaN) power MOSFETs. Driver U1 is preferably a MOSFET driver IC, for example. A voltage VCC is preferably provided from a separate DC-DC voltage regulator (not shown) and input to the driver U1 according to the requirements of the driver U1. The separate DC-DC voltage regulator may provide the voltage VCC from the high-voltage terminal Vhigh, the low-voltage terminal Vlow, or an external power source. Preferably, the voltage VCC is between about 8 V and about 14 V.

The bidirectional current-sensing circuit 110 preferably includes the secondary windings (S1 and S2) of the two current-sense transformers (TX1 and TX2), eleven resistors (R1, R3, R5, R6, R7, R8, R11, R12, R13, R14, and R17), four transistors (Q3, Q4, Q5, an Q6), six capacitors (C1, C2, C3, C4, C5, and C10), and three diodes (D1, D2, and D5), for example. Transistors Q3, Q4, Q5, and Q6 are preferably MOSFETs, and more preferably small signal MOSFETs with relatively low drain-to-source resistances Rdson, for example. However, transistors Q3, Q4, Q5, and Q6 may also be small-signal bipolar transistors with relatively low Vce saturation values (as compared with the voltage drop across resistor R1). Diode D2 preferably is a Schottky diode, for example.

The output of the bidirectional current-sensing circuit 110 is a current-sense voltage Isense that provides a voltage waveform that represents the current flowing through transistors Q1 and Q2 of the bidirectional non-isolated DC-DC converter 100. The voltage waveform of the current-sense voltage Isense during an ON time of the buck or boost modes can be used, for example, for (1) average- or peak-current-mode control, (2) overcurrent protection, (3) output current measurement, and (4) current sharing.

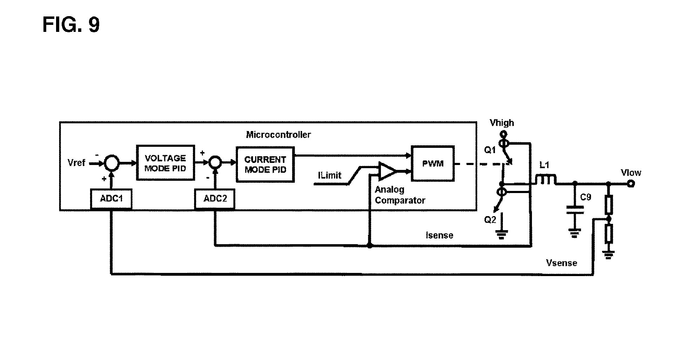

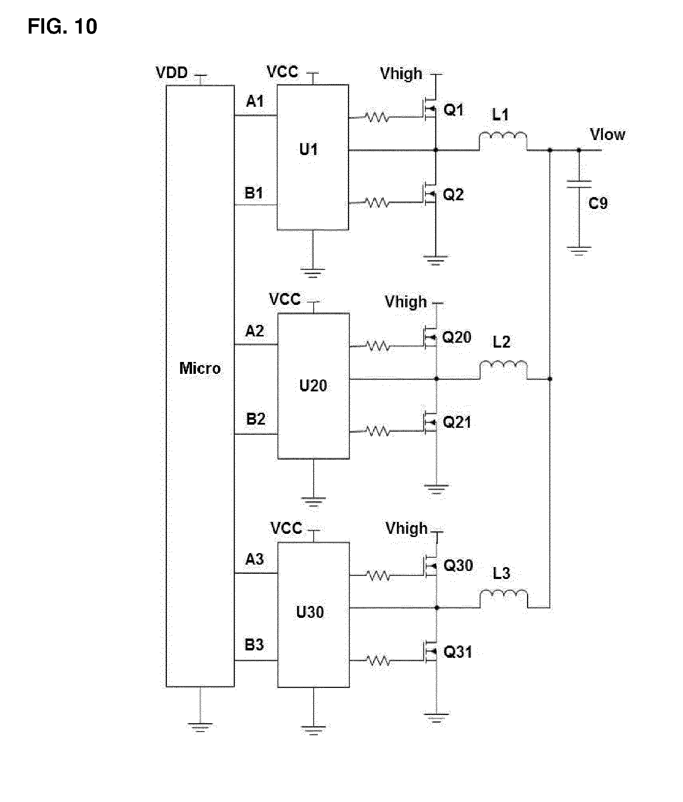

Fig. 9 is a circuit diagram of an average current-mode control circuit and Fig. 10 is a circuit diagram of a multi-phase converter according to preferred embodiments of the present invention. As shown in Fig. 9, the current-sense voltage Isense can be input to a microcontroller that controls the bidirectional non-isolated DC-DC converter 100 shown in Fig. 1 or the multi-phase DC-DC converter shown in Fig. 10. As shown in Fig. 9, a voltage divider at the low-voltage terminal Vlow provides a voltage-sense signal Vsense to a first analog-to-digital converter ADC1 of the microcontroller, and the current-sense voltage Isense is preferably input to a second analog-to-digital converter ADC2 and an analog comparator of the microcontroller. The voltage divider preferably lowers the voltage of the low-voltage terminal Vlow to a level that is usable by the first analog-to-digital converter ADC1 (for example, below 3.3 V). Preferably, a digital reference voltage Vref is generated by the microcontroller and sets the value of the low-voltage terminal Vlow. The microcontroller preferably further includes a voltage-mode proportional-integral-derivative (PID) controller that receives the difference between digital reference voltage Vref and the output of the first analog-to-digital converter ADC1. The difference between the output of the voltage-mode PID controller and the output of the second analog-to-digital converter ADC2 is preferably input to a current-mode PID controller. The output of the current-mode PID controller is provided to a pulse-width-modulation controller PWM, which outputs a signal for controlling the transistors Q1 and Q2. Preferably, a current-limit reference signal ILimit is also generated by the microcontroller and input to the analog comparator along with the current-sense voltage Isense. If the analog comparator determines that the current-sense voltage Isense signal exceeds the current-limit reference signal ILimit, then the pulse-width-modulation controller PWM is preferably shut down.

The microcontroller shown in Fig. 9 preferably samples the current-sense voltage Isense in the middle of the ON time of the buck or boost modes to determine an average current, for example, if the bidirectional non-isolated DC-DC converter 100 shown in Fig. 1 is used with the average current-mode control circuit shown in Fig. 9 and is operating in a continuous conduction mode, which is used to perform current sharing among the multiple phases of the converter. Instead of ADCs, the current-sense voltage Isense may be input to an analog comparator of the microcontroller. The microcontroller preferably detects if an over-current condition has occurred by determining if the current-sense voltage Isense has exceeded a predetermined voltage level so that the current can be limited.

As shown in Fig. 10, a multi-phase DC-DC converter may include three separate isolated DC-DC converters that are similar to the bidirectional non-isolated DC-DC converter 100 shown in Fig. 1. Preferably, the second and third drivers U20 and U30 shown in Fig. 10 are similar to the driver U1 shown in Fig. 1; the transistors Q20 and Q30 are similar to the transistor Q1 shown in Fig. 1; the transistors Q21 and Q31 are similar to the transistor Q2 shown in Fig. 1; and the inductors L2 and L3 are similar to the inductor L1 shown in Fig. 1. However, as shown in Fig. 10, the multi-phase DC-DC converter preferably includes a single microcontroller that controls each of the transistors Q1, Q2, Q20, Q21, Q30, and Q31 by respective signals A1, B1, A2, B2, A3, and B3 that are output to drivers U1, U20, and U30. Preferably, each of the transistors Q1, Q20, and Q30 is connected to a single common high-voltage terminal Vhigh and each of the inductors L1, L2, and L3 is connected to a single low-voltage terminal Vlow, as shown in Fig. 10. The microcontroller shown in Fig. 10 preferably detects if an over-current condition has occurred by determining if a sensed current a predetermined level so that the current can be limited or one of the phases of the multi-phase DC-DC converter can be turned off. The multi-phase DC-DC converter of Fig. 10 may be used to provide POL (point-of-load) high-current, low-voltage power for CPUs, chipsets, peripherals, and the like. However, the preferred embodiments of the present invention are not so limited, and the current-sense voltage Isense may be used as an input for any appropriate circuit.

When the bidirectional non-isolated DC-DC converter 100 operates in the buck mode, transistor Q1 conducts during the ON time and transistor Q2 conducts during the OFF time. That is, during the ON time in the buck mode, the driver U1 outputs a voltage at terminal HO that drives the transistor Q1 to turn on and conduct current. Resistor R15, resistor R16, and diode D3 can be included between terminal HO and the gate terminal of transistor Q1 to control the timing of transistor Q1, which would otherwise be based upon the internal gate resistor of transistor Q1 and the internal pull-up and pull-down resistances of the driver U1. Specifically, resistor R15 can control the turn-on timing of transistor Q1 by setting the voltage at the gate of transistor Q1 to be above the gate-threshold voltage of transistor Q1. Preferably, the voltage at the gate of transistor Q1 is set to be sufficiently above the gate-threshold voltage of transistor Q1 to reduce the power dissipation due to the Rdson of transistor Q1. Resistor R16 and diode D3 can control the turn-off timing of transistor Q1. However, any other appropriate circuit can also be used in place of resistor R15, resistor R16, and diode D3.

During the OFF time in the buck mode, the driver U1 outputs a voltage at terminal LO that drives the transistor Q2 to turn on and conduct current. Similar to resistor R15 described above, resistor R2 can control the turn-on timing of transistor Q2 by setting the voltage at the gate of transistor Q2 to be above the gate-threshold voltage of transistor Q2. Similar to resistor R16 and diode D3 described above, resistor R4 and diode D4 can control the turn-off timing of transistor Q2. However, any other appropriate circuit can also be used in place of resistor R2, resistor R4, and diode D4. Terminal HS of the driver U1 is a switching node used to drive the high-side transistor (i.e., transistor Q1) and generate a high-side bootstrap voltage via capacitor C11. Terminal HB of the driver U1 is a high-side bootstrap supply input. A "dead time" exists between when transistor Q1 is turned off and when transistor Q2 is turned on and between when transistor Q2 is turned off and when transistor Q1 is turned on so that both transistors Q1 and Q2 are not on at the same time. If both transistors Q1 and Q2 are on at the same time, a condition known as "shoot-through" may occur, which reduces the efficiency of the bidirectional non-isolated DC-DC converter 100 due to overheating and power loss. Instead of the driver U1, transistors Q1 and Q2 may be driven by, for example, discrete gate-drive circuits, such as gate-drive transformer circuits. However, the driver U1 is preferably used for reliability and to minimize the overall size of the bidirectional non-isolated DC-DC converter 100.

During the ON time of the buck-mode operation of the bidirectional non-isolated DC-DC converter 100, energy is stored in the inductor L1 due to a flow of current being established from the high-voltage terminal Vhigh, through the primary winding P1 of the current-sense transformer TX1 (into the dotted end of the primary winding P1), through the transistor Q1 (from the drain terminal to the source terminal of transistor Q1), through the inductor L1, and to a load at the low-voltage terminal Vlow. Transistors Q3 and Q5 are on because the terminal HO of the driver U1 is synchronized or substantially synchronized (slight delays may be introduced due to propagation delays within the driver U1) with the terminal HI of the driver U1. Accordingly, the current induced in the secondary winding S1 of current-sense transformer TX1 (out of the dotted end of the secondary winding S1) causes current to flow through the transistor Q3 (from the source terminal to the drain terminal of transistor Q3), through the transistor Q5 (from the drain terminal to the source terminal of transistor Q5), and through the resistor R1 to ground. Schottky diode D2 clamps the voltage across resistor R1 to a Schottky diode drop. Preferably, Schottky diode D2 is selected so that the forward voltage drop and the leakage current are minimized with respect to the desired operating temperature. Capacitor C4 is a filter capacitor for resistor R1, and capacitor C5 is a filter capacitor for the current-sense voltage Isense.

Transistor Q2 is off during the ON time of the buck-mode operation of the bidirectional non-isolated DC-DC converter 100. Transistors Q4 and Q6 are also off during this time so that the current-sense transformer TX2 does not conduct current and is allowed to reset. Transistor Q4 prevents transistor Q6 from conducting current, for example, due to a body diode of transistor Q6, when transistor Q6 is off. Resistor R8 is arranged across the secondary winding S2 to reduce the reset time of the current-sense transformer TX2, especially at higher duty cycles.

During the OFF time of the buck-mode operation of the bidirectional non-isolated DC-DC converter 100, energy stored in the inductor L1 during the ON time discharges such that current flows from ground, through transistor Q2 (from the source terminal to the drain terminal of transistor Q2), through the primary winding P2 of current-sense transformer TX2 (out of the dotted end of the primary winding P2), through the inductor L1, and to the low-voltage terminal Vlow load. Transistors Q4 and Q6 are on because the terminal LO of the driver U1 is synchronized or substantially synchronized (slight delays may be introduced due to propagation delays within the driver U1) with the terminal LI of the driver U1. Accordingly, the current induced in the secondary winding S2 of the current-sense transformer TX2 (into dotted end of the secondary winding S2) causes current to flow through the resistor R1 (ground to the source terminal of transistor Q4) and Schottky diode D2, through the transistor Q4 (from the source terminal to the drain terminal of transistor Q4), and through the transistor Q6 (from the drain terminal to the source terminal of transistor Q6). As described above, Schottky diode D2 clamps the voltage across resistor R1 to a Schottky diode drop.

Transistor Q1 is off during the OFF time of the buck-mode operation of the bidirectional non-isolated DC-DC converter 100. Transistors Q3 and Q5 are also off during this time so that current-sense transformer TX1 does not conduct current and is allowed to reset. Transistor Q5 prevents transistor Q3 from conducting current, for example, due to a body diode of transistor Q3, when transistor Q3 is off. Resistor R7 is arranged across the secondary winding S1 to reduce the reset time of the current-sense transformer TX1, especially at higher duty cycles.

The current-sense voltage Isense is biased up via resistor R5, resistor R6, and a reference voltage VDD. The reference voltage VDD is preferably provided from a separate DC-DC voltage regulator (not shown) that is connected to the high-voltage terminal Vhigh, the low-voltage terminal Vlow, or an external power source. Voltage VCC and reference voltage VDD can be provided by the same DC-DC voltage regulator. However, because reference voltage VDD must be more tightly controlled than voltage VCC, separate sources for the voltage VCC and the reference voltage VDD may be used. Preferably, resistor R5 has a resistance that is approximately ten times greater than the resistance of resistor R6, for example. Therefore, if the load at low-voltage terminal Vlow is zero amps, and the reference voltage VDD is about 3.3 V, for example, the average value of the current-sense voltage Isense (during the ON time of the buck-mode operation of the bidirectional non-isolated DC-DC converter 100) will be about 0.3 V, for example. As a result, negative load currents at low-voltage terminal Vlow will have an average value of the current-sense voltage Isense (during the ON time of the buck-mode operation of the bidirectional non-isolated DC-DC converter 100) that is below about 0.3 V. Bidirectional non-isolated DC-DC converter 100 allows both positive and negative current because transistor Q2 conducts current in both directions. If multiple DC-DC converters, including the bidirectional non-isolated DC-DC converter 100, are arranged in parallel and operate under certain operation conditions (e.g., light loading or load transients), current sharing differences between the multiple DC-DC converters may cause one (or more) of the DC-DC converters to sink current rather than source current. Thus, the overall current loop formed by the multiple DC-DC converters must include current sensing to determine if one (or more) of the DC-DC converters is trying to sink current (i.e., providing a negative load current), so that the overall current loop can be adjusted to force the current-sinking DC-DC converters to source current. Accordingly, negative currents must be measured in both buck-mode and boost-mode so that each DC-DC converter can be controlled.

Signal A and signal B control the on and off switching of transistors Q3, Q4, Q5, and Q6. Signals A and B are preferably generated by a controller according to the current-sense voltage Isense. Signals A and B may also be generated based on other factors such as the voltages at the high- and low-voltage terminals Vhigh and Vlow, the measured temperature, and the like. The controller for generating signals A and B may be a microcontroller, a PWM controller, and/or a controller that includes MOSFET drivers that replace the driver U1. Preferably, signals A and B each pass through an adjustable RC circuit prior to reaching the gate terminals of transistors Q3, Q4, Q5, and Q6. As shown in Fig. 1, an example of an RC circuit for transistors Q3 and Q5 includes resistor R12, resistor R17, diode D5, and capacitor C2, and an example of an RC circuit for transistors Q4 and Q6 includes resistor R3, resistor R13, diode D1, and capacitor C10. However, any other appropriate circuits may be used as the RC circuits for transistors Q3, Q4, Q5, and Q6. Preferably, a delay is included before transistors Q3 and Q6 are turned on to reduce the inrush current through capacitors C2 and C10. Further, the delay preferably causes the transistors Q3 and Q6 to turn off after transistors Q1 and Q2 turn off to ensure that the current signals of the current through the secondary windings S1 and S2 includes, without clipping, the entire current waveforms through the primary windings P1 and P2. Particularly, the delay in turning off transistors Q3 and Q6 compensates for delays that occur on the primary side of the bidirectional non-isolated DC-DC converter 100, for example, propagation delays in the driver U1.

Capacitor C1 and resistor R14 form a snubber circuit that limits ringing when transistor Q3 is turned off, and capacitor C3 and resistor R11 form a capacitor circuit that limits ringing when transistor Q6 is turned off. Capacitor C6 and resistor R9 form a damping snubber circuit that limits ringing in the primary winding P1, and capacitor C7 and resistor R10 form a damping snubber circuit that limits ringing in the primary winding P2.

Figs. 2-4 show waveforms associated with the bidirectional non-isolated DC-DC converter 100 shown in Fig. 1 operating in a buck mode.

Fig. 2 shows measured voltage waveforms of signal A, signal B, and the current-sense voltage Isense when the bidirectional non-isolated DC-DC converter 100 operates in the buck mode with a voltage of about 48 V at the high-voltage terminal Vhigh, a voltage of about 12 V at the low-voltage terminal Vlow, and a load of about 5 A at the low-voltage terminal Vlow. The switching frequency of the bidirectional non-isolated DC-DC converter 100 preferably is about 250 kHz, for example. The measured voltage waveforms of signals A and B are shown at 2 V per division, and the measured waveform for the current-sense voltage Isense is shown at 0.5 V per division. As shown in Fig. 2, with the 5 A load at the low-voltage terminal Vlow, the average value of the current-sense voltage Isense (during the ON time of the buck-mode operation of the bidirectional non-isolated DC-DC converter 100) is approximately 0.8 V, for example. Preferably, an average current of about 50 mA flows through the resistor R1 and the diode D2, which are in parallel. The current-sense voltage Isense is then determined by a voltage divider formed by the reference voltage VDD, the resistor R5, and the resistor R6, minus the voltage across the resistor R1 and the diode D2, which results in a voltage that is close to zero. Accordingly, when a load is present, the resistor R1 and the diode D2 influence the current-sense voltage Isense. However, if there is no load, the resistor R1 and the diode D2 do not influence the current-sense voltage Isense.

Fig. 3 shows measured voltage waveforms similar to those shown in Fig. 2, except that the load at the low-voltage terminal Vlow has been changed to about 0 A. The measured voltage waveforms of signals A and B are shown at 2 V per division, and the measured waveform for the current-sense voltage Isense is shown at 0.2 V per division. As shown in Fig. 3, with the 0 A load at the low-voltage terminal Vlow, the average value of the current-sense voltage Isense (during the ON time of the buck-mode operation of the bidirectional non-isolated DC-DC converter 100) preferably is approximately 0.3 V, for example. With no load at the low-voltage terminal Vlow, the current-sense voltage Isense is about 0.3 V due to the voltage divider formed by the reference voltage VDD, the resistor R5, and the resistor R6. For example, Fig. 3 shows a waveform for the current-sense voltage Isense that is obtained when the reference voltage VDD is about 3.3 V, the resistor R5 is about 511 Ω, and the resistor R6 is about 5110 Ω.

With a full-scale voltage set to 1.5 V, for example, a full load at the low-voltage terminal Vlow results in the current-sense voltage Isense being about 1.5 V. Thus, as described above, a value of 0.3 V for the current-sense voltage Isense represents a zero current load (i.e., no load). Accordingly, values between 0 V and 0.3 V for the current-sense voltage Isense represent negative current loads, and values between 0.3 V and 1.5 V for the current-sense voltage Isense represent positive current loads. However, based on the maximum allowable current for the bidirectional non-isolated DC-DC converter 100, an overcurrent condition may be detected when the current-sense voltage Isense reaches a voltage that is slightly below 1.5 V to ensure that the current remains below the maximum allowable current.

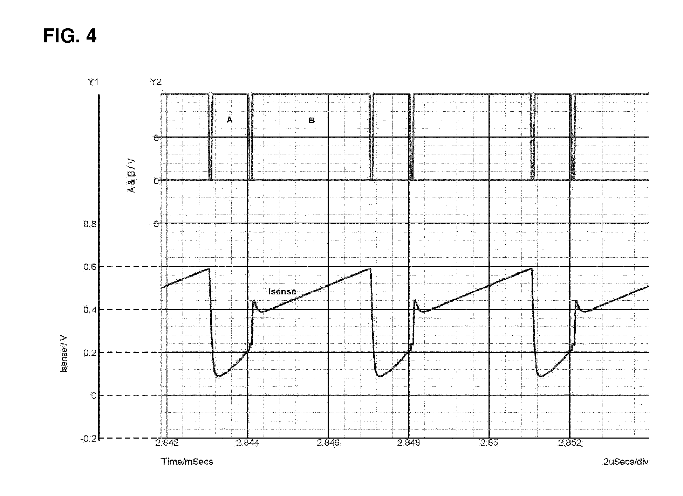

Fig. 4 shows simulated voltage waveforms of signal A, signal B, and the current-sense voltage Isense when the bidirectional non-isolated DC-DC converter 100 operates in buck mode with a voltage of about 48 V at the high-voltage terminal Vhigh, a voltage of about 12 V at the low-voltage terminal Vlow, and a load of about -2 A at the low-voltage terminal Vlow. The switching frequency of the bidirectional non-isolated DC-DC converter 100 is about 250 kHz, for example. The simulated voltage waveforms of signals A and B are shown at 5 V per division, and the simulated waveform for the current-sense voltage Isense is shown at 0.2 V per division. As shown in Fig. 4, with the -2 A load at the low-voltage terminal Vlow, the average value of the current-sense voltage Isense (during the ON time of the buck-mode operation of the bidirectional non-isolated DC-DC converter 100) is approximately 0.13 V, for example.

When the bidirectional non-isolated DC-DC converter 100 operates in the boost mode, transistor Q2 conducts during the ON time and transistor Q1 conducts during the OFF time. That is, during the ON time in the boost mode, the driver U1 outputs a voltage at terminal LO that drives the transistor Q2 to turn on and conduct current. Similarly, during the OFF time in the buck mode, the driver U1 outputs a voltage at terminal HO that drives the transistor Q1 to turn on and conduct current. A "dead time" exists between when transistor Q2 is turned off and when transistor Q1 is turned on and between when transistor Q1 is turned off and when transistor Q2 is turned on so that both transistors Q1 and Q2 are not on at the same time. If both transistors Q1 and Q2 are on at the same time, a condition known as "shoot-through" may occur, which reduces the efficiency of the bidirectional non-isolated DC-DC converter 100 due to overheating and power loss.

During the ON time of the boost-mode operation of the bidirectional non-isolated DC-DC converter 100, energy is stored in the inductor L1 due to a flow of current being established from low-voltage terminal Vlow, through the inductor L1, through the primary winding P2 of current-sense transformer TX2 (into the dotted end of the primary winding P2), through transistor Q2 (from the drain terminal to the source terminal of transistor Q2) and to ground. Transistors Q4 and Q6 are on because of terminal LO of the driver U1 is synchronized or substantially synchronized (slight delays may be introduced due to propagation delays within the driver U1) with the terminal LI of the driver U1. Accordingly, the current induced in the secondary winding S2 of the current-sense transformer TX2 (out of the dotted end of the secondary winding S2) causes current to flow through the transistor Q6 (from the source terminal to the drain terminal of transistor Q6), through the transistor Q4 (from the drain terminal to the source terminal of transistor Q4), and through the resistor R1 to ground. As described above, Schottky diode D2 clamps the voltage across resistor R1 to a Schottky diode drop.

Transistor Q1 is off during the ON time of the boost-mode operation of the bidirectional non-isolated DC-DC converter 100. Transistors Q3 and Q5 are also off during this time so that the current-sense transformer TX1 does not conduct current and is allowed to reset.

During the OFF time of the boost-mode operation of the bidirectional non-isolated DC-DC converter 100, energy stored in the inductor L1 during the ON time discharges such that current flows from low-voltage terminal Vlow, through inductor L1, through transistor Q1 (from the source terminal to the drain terminal of transistor Q1), through the primary winding P1 of current-sense transformer TX1 (out of the dotted end of the primary winding P1), and to the high-voltage terminal Vhigh load. Transistors Q3 and Q5 are also on due to terminal HO of the driver U1 being synchronized or substantially synchronized (slight delays may be introduced due to propagation delays within the driver U1) with the terminal HI of the driver U1 Accordingly, the current induced in the secondary winding S1 of the current-sense transformer TX1 (into dotted end of the secondary winding S1) causes current to flow through the resistor R1 (ground to the source terminal of transistor Q5), through the transistor Q5 (from the source terminal to the drain terminal of transistor Q5), through the transistor Q3 (from the drain terminal to the source terminal of transistor Q3), and through the resistor R1. As described above, Schottky diode D2 clamps the voltage across resistor R1 to a Schottky diode drop.

Transistor Q2 is off during the OFF time of the boost-mode operation of the bidirectional non-isolated DC-DC converter 100. Transistors Q4 and Q6 are also off during this time which allows the inactive current-sense transformer TX2 to reset.

Figs. 5-7 show waveforms associated with the bidirectional non-isolated DC-DC converter 100 shown in Fig. 1 operating in a boost mode.

Fig. 5 shows measured voltage waveforms of signal A, signal B, and the current-sense voltage Isense when the bidirectional non-isolated DC-DC converter 100 operates in boost mode with a voltage of about 48 V at the high-voltage terminal Vhigh, a voltage of about 12 V at the low-voltage terminal Vlow, and a load of about 1 A at the high-voltage terminal Vhigh. The switching frequency of the bidirectional non-isolated DC-DC converter 100 is about 250 kHz, for example. The measured voltage waveforms of signals A and B are shown at 2 V per division, and the measured waveform for the current-sense voltage Isense is shown at 0.5 V per division. As shown in Fig. 5, with the 1 A load at the high-voltage terminal Vhigh, the average value of the current-sense voltage Isense (during the ON time of the boost-mode operation of the bidirectional non-isolated DC-DC converter 100) is approximately 0.75 V, for example.

Fig. 6 shows measured voltage waveforms similar to those shown in Fig. 5, except that the load at high-voltage terminal Vhigh is has been changed to about 0 A. The measured voltage waveforms of signals A and B are shown at 2 V per division, and the measured waveform for the current-sense voltage Isense is shown at 0.2 V per division. As shown in Fig. 6, with the 0 A load at the low-voltage terminal Vlow, the average value of the current-sense voltage Isense (during the ON time of the boost-mode operation of the bidirectional non-isolated DC-DC converter 100) is approximately 0.3 V, for example. With no load at the low-voltage terminal Vlow, the current-sense voltage Isense is about 0.3 V due to the voltage divider formed by the reference voltage VDD, the resistor R5, and the resistor R6.

With a full-scale voltage set to 1.5 V, for example, a full load at the low-voltage terminal Vlow results in the current-sense voltage Isense being about 1.5 V. Thus, as described above, a value of 0.3 V for the current-sense voltage Isense represents a zero current load (i.e., no load). Accordingly, values between 0 V and 0.3 V for the current-sense voltage Isense represent negative current loads, and values between 0.3 V and 1.5 V for the current-sense voltage Isense represent positive current loads. However, based on the maximum allowable current for the bidirectional non-isolated DC-DC converter 100, an overcurrent condition may be detected when the current-sense voltage Isense reaches a voltage that is slightly below 1.5 V to ensure that the current remains below the maximum allowable current.

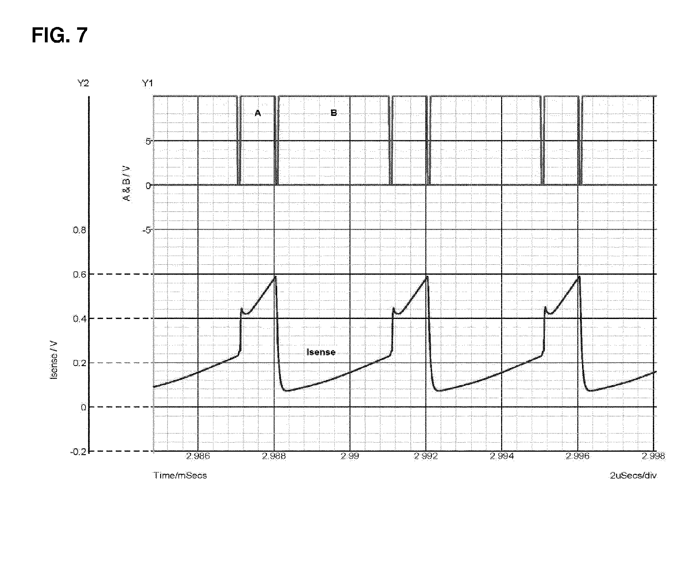

Fig. 7 shows simulated voltage waveforms of signal A, signal B, and the current-sense voltage Isense when the bidirectional non-isolated DC-DC converter 100 operates in boost mode with a voltage of about 48 V at the high-voltage terminal Vhigh, a voltage of about 12 V at the low-voltage terminal Vlow, and a load of about -0.5 A at the high-voltage terminal Vhigh. The switching frequency of the bidirectional non-isolated DC-DC converter 100 is about 250 kHz, for example. The simulated voltage waveforms of signals A and B are shown at 5 V per division, and the simulated waveform for the current-sense voltage Isense is shown at 0.2 V per division. As shown in Fig. 7 with the -0.5 A load at the high-voltage terminal Vhigh, the average value of the current-sense voltage Isense (during the ON time of the boost-mode operation of the bidirectional non-isolated DC-DC converter 100) is approximately 0.13 V, for example.

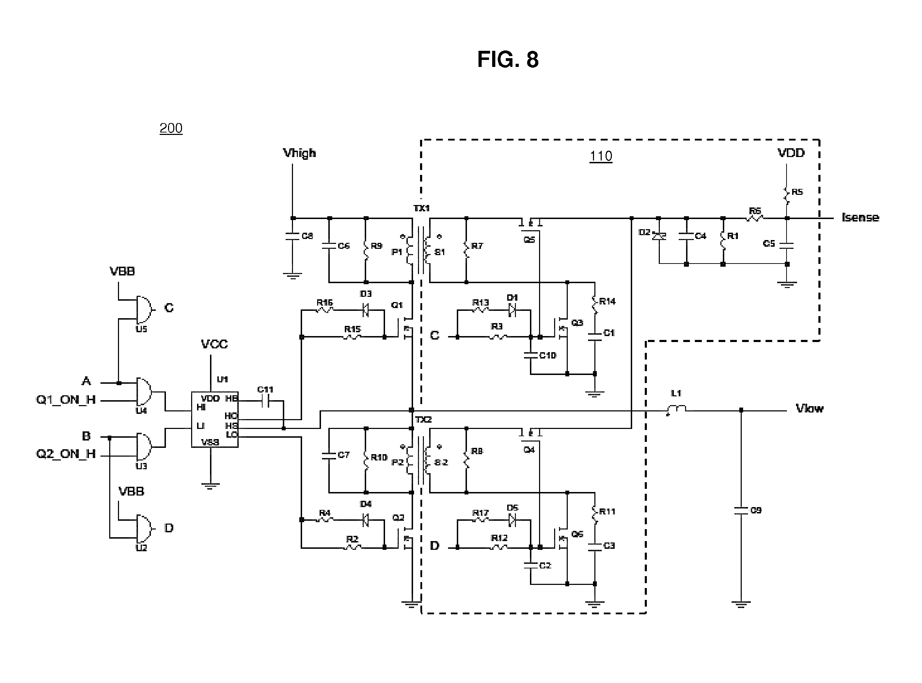

Fig. 8 is a circuit diagram of a bidirectional non-isolated DC-DC converter 200 including the bi-directional current-sensing circuit 110 according to a second preferred embodiment of the present invention.

As shown in Fig. 8, most of the circuit elements of the bidirectional non-isolated DC-DC converter 200 preferably are the same as those of the bidirectional non-isolated DC-DC converter 100 shown in Fig. 1. However, the bidirectional non-isolated DC-DC converter 200 additionally includes AND gates U2, U3, U4, and U5. As shown in Fig. 8, a bias voltage VBB and signal B are input to AND gate U2, signal B and a signal Q2_ON_H are input to AND gate U3, signal A and a signal Q1_ON_H are input to AND gate U4, and the bias voltage VBB and signal A are input to AND gate U5. Bias voltage VBB is a reference voltage that preferably has a voltage level that is set to be approximately half of the high-signal voltage levels of signals A, B, Q1_ON_H, and Q2_ON_H. For example, if the signals A, B, Q1_ON_H, and Q2_ON_H are transistor-transistor logic (TTL) signals provided from a microcontroller and set to have high-signal voltage levels of 3.3 V, the bias voltage VBB is preferably set to be about 1.65 V. Preferably, the bias voltage VBB is generated from a shunt or series voltage reference. However, the bias voltage VBB may instead be generated similar to the voltage VCC and the reference voltage VDD as described above. The signal Q1_ON_H is a signal that is used to disable transistor Q1 by turning transistor Q1 off regardless of the level of signal A, and to enable transistor Q1 to turn on and off with the level of signal A. Similarly, the signal Q2_ON_H is a signal that is used to disable transistor Q2 by turning transistor Q2 off regardless of the level of signal B, and to enable transistor Q2 to turn on and off with the level of signal B. For example, when a light load is connected to the bidirectional non-isolated DC-DC converter 200, transistor Q1 may be disabled in boost mode to increase efficiency and transistor Q2 may be disabled in buck mode to increase efficiency. As another example, transistors Q1 and Q2 may be selectively disabled in a multi-phase converter, such as the multi-phase converter shown in Fig. 10, during phase shedding (e.g., when one or more phases are turned off). However, even if transistor Q1 or Q2 is disabled, it is preferable that the current-sensing circuit 110 still performs its normal mode of operation via signal A and signal B.

AND gate U2 outputs a signal D that controls the on and off switching of transistors Q4 and Q6. AND gate U5 outputs a signal C that controls the on and off switching of transistors Q3 and Q5. AND gates U3 and U4 allow the bidirectional current-sensing circuit 110 to operate even when transistors Q1 and Q2 are both turned off such as during the "dead time" of both buck mode and boost mode. Because the bidirectional current-sensing circuit 110 operates even when both transistors Q1 and Q2 are turned off, the bidirectional non-isolated DC-DC converter 200 may operate in asynchronous modes (i.e., transistor Q2 off in buck mode or transistor Q1 off in boost mode), which provides easier start-up of the bidirectional non-isolated DC-DC converter 200 during, for example, light-load conditions. During start-up of the bidirectional non-isolated DC-DC converter 200, transistor Q1 is preferably turned off in buck-mode and transistor Q2 is preferably turned off in boost-mode if the bidirectional non-isolated DC-DC converter 200 is implemented as a multi-phase converter or shares current with other voltage converters.

When the signals A and B are driven by a low-voltage signal such as a 3.3 V TTL signal, the bidirectional non-isolated DC-DC converter 200 shown in Fig. 8 is able to provide higher voltages to the gate terminals of transistors Q3, Q4, Q5, and Q6 as compared with the bidirectional non-isolated DC-DC converter 100 shown in Fig. 1. For example, if the AND gates U2 and U5 are powered by a 5 V source (not shown in Fig. 8), then the output of the AND gates U2 and U5 will be 5 V. Preferably, AND gates U2 and U5 are AND gates that are powered by a higher-voltage bus (e.g., 5 V) and are able to accept a lower-voltage input (e.g., a 3.3 V TTL signal) and output a higher voltage signal (e.g., 5 V). For example, if signals A and B are 3.3 V TTL signals, signals C and D may instead be 5 V signals so that the full-scale voltage of the current-sense voltage Isense can be higher than the full-scale voltage for the bidirectional non-isolated DC-DC converter 100 shown in Fig. 1. Additionally, if a full-scale range of the current-sense voltage Isense is increased, higher voltages are preferably used to drive the gate terminals of transistors Q4 and Q5. For example, if the full-scale voltage of the current-sense voltage Isense is 1.5 V (i.e., the highest possible voltage of the current-sense voltage Isense is 1.5 V), the minimum gate-to-source voltage of each of transistors Q4 and Q5 is the corresponding voltage of signals C and D (e.g., 3.3 V) minus the full-scale voltage of the current-sense voltage Isense (e.g., 1.5 V). Thus, according to this example, the minimum gate-to-source voltage of each of transistors Q4 and Q5 is only 1.8 V. Increasing the full-scale voltage of the current-sense voltage Isense, for example, to 3.3 V requires a higher voltage for the signals C and D (i.e., 3.3 V + 1.8 V = 5.1 V) to keep the minimum gate-to-source voltage of transistors Q4 and Q5 at the same voltage of 1.8 V. The gate-to-source voltage of transistors Q4 and Q5 is maintained at the same voltage level of 1.8 V to ensure proper turn-on of transistors Q4 and Q5.

The AND gates U2, U3, U4, and U5 are preferably high-speed AND gates to reduce propagation delays between the signals A and B (which control transistors Q1 and Q2 of the bidirectional non-isolated DC-DC converter 200), the driver U1, and signals C and D (which control transistors Q3, Q4, Q5, and Q6 of the bidirectional current-sensing circuit 110).

The bidirectional current-sensing circuit 110 of the preferred embodiments of the present invention is not limited to bidirectional non-isolated DC-DC converters, and can be used with other topologies of voltage converters that include two complimentary switches and require bidirectional current sensing. As one example of such an alternative, the bidirectional current-sense circuit 110 can be used with a DC-DC converter that operates in a diode emulation mode, or with multiple DC-DC converters that are operated in parallel. In a diode emulation mode of a DC-DC converter, the bottom transistor (i.e., transistor Q2) is turned off during conditions such as a light load to improve the overall efficiency of the DC-DC converter.

According to the preferred embodiments of the present invention, current-sense transformers TX1 and TX2 allow bidirectional current sensing to be performed without using components that cause significant power loss, such as operational amplifiers or sense resistors.

Furthermore, the preferred embodiments of the present invention provide instantaneous current measurements of the current flowing through transistors Q1 and Q2, even at high switching frequencies.

The preferred embodiments of the present invention also provide a full-scale current-sense signal regardless of the direction of current in a voltage converter. This is achieved by proper sequencing of the current-sense transformers TX1 and TX2. That is, by allowing the current-sense transformers TX1 and TX2 to alternatingly reset, the current-sense voltage Isense is usable regardless of whether the voltage converter is operating in buck-mode or boost-mode.

The preferred embodiments of the present invention provide a current-sensing circuit for sensing both positive and negative currents. According to the preferred embodiments of the present invention, the voltage signal representing the sensed currents can be biased up, such that negative currents are represented as a positive sense voltage.

While preferred embodiments of the present invention have been described above, it is to be understood that variations and modifications will be apparent to those skilled in the art without departing the scope and spirit of the present invention. The scope of the present invention, therefore, is to be determined solely by the following claims.

## Claims

1. A bi-directional voltage converter with a current-sensing circuit comprising:
a first sub-circuit including a high-voltage terminal, a first switching device, and a first primary winding of a first transformer connected in series with each other;
a second sub-circuit including a second switching device, a second primary winding of a second transformer, and a ground terminal connected in series with each other;
a low-voltage terminal connected, via an inductor, to a point between the first sub-circuit and the second sub-circuit;
a third switching device and a first secondary winding of the first transformer connected in series with each other;
a fourth switching device and a second secondary winding of the second transformer connected in series with each other; and
a control circuit configured to control on and off switching of the first, second, third, and fourth switching devices; wherein
the third and fourth switching devices are included in the current-sensing circuit and are connected to a current-sense terminal; and
the current-sensing circuit generates a voltage waveform at the current-sense terminal representing a current flowing through at least one of the first switching device and the second switching device.

2. The bi-directional voltage converter with current-sensing circuit according to claim 1, wherein:
the control circuit is configured to control the first and third switching devices to turn on and off at the same time or substantially at the same time; and
the control circuit is configured to control the second and fourth switching devices to turn on and off at the same time or substantially at the same time.

3. The bi-directional voltage converter with current-sensing circuit according to claim 1, wherein:
the control circuit is configured to control the third switching device to turn on or off at an end of a delay period after the first switching device turns on or off; and
the control circuit is configured to control the fourth switching device to turn on or off at an end of a delay period after the second switching device turns on or off.

4. The bi-directional voltage converter with current-sensing circuit according to claim 1, further comprising:
a first RC circuit connected between the control circuit and the third switching device and configured to delay the third switching device from turning on or off; and
a second RC circuit connected between the control circuit and the fourth switching device and configured to delay the fourth switching device from turning on or off.

5. The bi-directional voltage converter with current-sensing circuit according to claim 1, wherein:
the first and third switching devices are on and the second and fourth switching devices are off during an ON time of a buck-mode operation of the voltage converter; and
the first and third switching devices are off and the second and fourth switching devices are on during an OFF time of the buck-mode operation of the voltage converter.

6. The bi-directional voltage converter with current-sensing circuit according to claim 1, wherein:
the first and third switching devices are off and the second and fourth switching devices are on during an ON time of a boost-mode operation of the voltage converter; and
the first and third switching devices are on and the second and fourth switching devices are off during an OFF time of the boost-mode operation of the voltage converter.

7. The bi-directional voltage converter with current-sensing circuit according to claim 1, wherein:
the current-sense terminal includes a diode and an output resistor connected in parallel to ground; and
the diode is arranged to clamp a voltage across the output resistor to a voltage drop of the diode.

8. The bi-directional voltage converter with current-sensing circuit according to claim 1, wherein the current-sense terminal includes a reference voltage and a voltage divider arranged to bias the current-sense terminal.

9. The bi-directional voltage converter with current-sensing circuit according to claim 1, further comprising:
a fifth switching device connected in series with the third switching device and the first secondary winding; and
a sixth switching device connected in series with the fourth switching device and the second secondary winding; wherein
the control circuit is configured to turn the fifth switching device on or off at the same time or substantially at the same time as the third switching device; and
the control circuit is configured to turn the sixth switching device on or off at the same time or substantially at the same time as the fourth switching device.

10. The bi-directional voltage converter with current-sensing circuit according to claim 9, wherein:
the fifth switching device is arranged to prevent current from conducting through a body diode of the third switching device when the third switching device is off; and
the sixth switching device is arranged to prevent current from conducting through a body diode of the fourth switching device when the fourth switching device is off; or
wherein at least one of the first through sixth switching devices is a metal-oxide-semiconductor field-effect transistor.

11. The bi-directional voltage converter with current-sensing circuit according to claim 1, wherein:
the control circuit includes an analog-to-digital converter or an analog comparator; and
the current-sense terminal is connected the analog-to-digital converter or the analog comparator of control device.

12. The bi-directional voltage converter with current-sensing circuit according to claim 1, further comprising:
snubber circuits connected across each of the primary and secondary windings of each of the first and second transformers; wherein
the snubber circuits each include a resistor; and
wherein preferably at least one of the snubber circuits further includes a capacitor.

13. The bi-directional voltage converter with current-sensing circuit according to claim 1, further comprising:
a first AND gate including an output connected to a control terminal of the first switching device and inputs connected to a bias voltage and a control signal for the first switching device; and
a second AND gate including an output connected to a control terminal of the second switching device and inputs connected to the bias voltage and a control signal for the second switching device.

14. The bi-directional voltage converter with current-sensing circuit according to claim 1, further comprising:
a voltage divider connected to the low-voltage terminal; and
an average current-mode control circuit including a first input connected to the voltage divider and a second input connected to the current-sense terminal; wherein
the average-mode current control circuit includes the control circuit and a pulse-width-modulation controller; and
the pulse-width-modulation controller of the average current-mode control circuit outputs a pulse-width-modulation signal to control the first and second switching devices; and
wherein preferably the average-mode current control circuit includes:
a first analog-to-digital converter having inputs connected to the first input and a digital reference voltage, and an output connected to a voltage-mode controller;
a second analog-to-digital converter having inputs connected to the second input and an output of the voltage-mode controller, and an output connected to a current-mode controller; and
an analog comparator having inputs connected to the second input and a current-limit reference signal, and an output connected to the pulse-width-modulation controller.

15. A multi-phase voltage converter comprising:
the bi-directional voltage converter with current-sensing circuit according to claim 1; and
at least one secondary voltage converter connected in parallel with the bi-directional voltage converter; wherein
the at least one secondary voltage converter includes a secondary driver, a first secondary switching device connected to the high-voltage terminal, and a second secondary switching device connected to the low-voltage terminal via a secondary inductor; and
the control circuit is further configured to control on and off switching of the first secondary switching device and the second secondary switching device.
